# EUROPEAN PATENT APPLICATION

(11) **EP 4 790 575 A2**
(43) Date of publication of application: **12.08.2026**
(21) Application number: 25224952.9
(22) Date of filing: 18.12.2025
(51) Int. Cl.: G06F 17/14, G01S 7/35, H03M 7/30, G01S 7/288

(54) **DATA COMPRESSION IN TWO-DIMENSIONAL DATA STORAGE**

(30) Priority: 19.12.2024 US 202418988191
(71) Applicant: NXP B.V., 5656 AG Eindhoven (NL)
(72) Inventor: ALVES VENTURA da SILVA, Manuel José, 5656AG Eindhoven (NL); PETROV, Nikita, 5656AG Eindhoven (NL)
(74) Representative: Schwarzweller, Thomas

(57) **Abstract**

An apparatus and method for performing multiple dimensional Discrete Fourier Transforms. Data in R vectors of C elements is compressed and stored in a two-dimensional data structure, where an amount of compression is based on a respective weight of a windowing function that is applied to elements in that row when a column vector is read from the two-dimensional data structure memory circuit to create a windowed vector. A selected column vector is read, from the two-dimensional data structure, that contains a respective element from a selected column in each row of the two-dimensional data structure. A windowed vector is created by applying a windowing function to the selected column vector and a Discrete Fourier Transform is calculated of the windowed vector.

## Description

### BACKGROUND

### Field

Embodiments of the present invention generally relate to storing data to support digital signal processing, and more particularly relate to compressing stored data used to support processing of multi-dimensional data structures.

### Related Art

Various radar systems, such as Frequency Modulated Continuous Wave (FMCW) radar systems, perform frequency domain analyses to determine various parameters of objects reflecting transmitted signals. The range to an object is able to be determined based on a Discrete Fourier Transform (DFT) of a received signal and parameters of the transmitted signal such as frequency sweep rate. The velocity of an object is able to be determined based on assembling the frequency data vectors of a number of DFTs of a sequence of a number of FMCW radar chirps into rows of a two-dimensional data structure and then reading data vectors as columns of that two-dimensional data object and performing DFTs on those column data vectors. Various implementations that determine object velocity, other parameters, or combinations of these are able to store large amounts of data in one or more two-dimensional structures according to the designs of those implementations. Such large memory structures add costs and can restrict designs of integrated, relatively low cost FMCW systems.

### BRIEF DESCRIPTION OF THE DRAWINGS

Embodiments of the present invention is illustrated by way of example and is not limited by the accompanying figures, in which like references indicate similar elements. Elements in the figures are illustrated for simplicity and clarity and have not necessarily been drawn to scale.
FIG. 1 illustrates a radar system, according to an example.
FIG. 2 illustrates a received signal processor block diagram, according to an example.
FIG. 3 illustrates a windowing function, according to an example.
FIG. 4 illustrates a mantissa bit length vs. data vector sample number curve, according to an example.
FIG. 5 illustrates compressed data memory organization, according to an example.
FIG. 6 illustrates a two-dimensional data compression process, according to an example.
FIG. 7 is a diagram illustrating one example of an information processing system according to one or more embodiments of the present invention.

### DETAILED DESCRIPTION

The below described systems and methods operate to efficiently store Discrete Fourier Transform (DFT) data in a two-dimensional data structure memory circuit, such as a memory, where that data is read from the memory to be processed by a second DFT that is referred to as a slow time Fast Fourier Transform (FFT). In an example, the data is stored in a compressed form where the data compression is different for different parts of the two-dimensional data structure memory circuit and is based on a windowing function that is applied to the data when it is read from the two-dimensional data structure memory circuit in preparation for performing the slow time FFT on that data. In an example, the data compression is performed by varying the mantissa bit length of each data element stored in the two-dimensional data structure memory circuit such that data elements that are multiplied by a smaller windowing function value are stored with a shorter mantissa bit length. Storing some data values with a shorter mantissa bit length relative to data values that are multiplied by larger windowing function values allows more efficient use of available memory. Such improved efficiencies allow reduced memory requirements and adjustment of the amount of data compression for various stored data elements to allow a tradeoff between compression factor and achievable dynamic range.

In an example of the below described systems and methods, a Frequency Modulated Continuous Wave (FMCW) radar transmits a number of waveforms with linearly increasing frequency (called chirps). In some examples, the transmitted signal is transmitted through several transmit antennas. The set of the number of transmitted chirps is referred to as a radar frame that contains at least one chirp sequence of a given number of chirp periods.

As the FMCW signal(s) are transmitted, reflections off of targets in the scene into which the transmissions are directed are received, possibly by several receive antennas. These received signals are downmixed into a baseband signal. A two-dimensional Discrete Fourier Transform (DFT) can then be applied to the received and downmixed reflections to resolve the distance to the target (by what is referred to as a fast time DFT that is determined with data collected during a single chirp) and velocity (by what is referred to as a slow time DFT that is determined based on data collected during several chirps of a radar frame). In an example, a two-dimensional DFT is calculated in two steps as two DFTs by performing Fast Fourier Transforms (FFTs).

In a first step of calculating a two-dimensional DFT, a first dimension DFT is calculated to produce a DFT frequency domain data vector based on digitized samples of one chirp period of the received waveform. The digitized data collected during reception of one chirp period is referred to as fast time samples and the DFT frequency domain data vector of the samples of each chirp period is referred to as a fast time DFT. In an example, the fast time DFT data is stored as data in a two-dimensional data structure with one fast time DFT stored in a separate row of the two-dimensional data structure.

In an example, a second step of calculating a two-dimensional DFT includes calculating a respective DFT for each chirp period directly after each chirp period is received. The fast time samples arrive and are processed immediately, and secondly along the slow time dimension. In order to proceed to the slow time dimension, the fast time DFT for all the chirps are calculated and stored in a memory, in a structure that is usually called the range cube. The range cube is a large block of data that is saved in memory during the real-time processing cycle. Data used for subsequent processing after storing data in the range cube, e.g., processing to determine Doppler shifts and Direction of Arrival (DOA) parameters, is generally performed on small blocks of range cells. In order to conserve or reduce memory storage requirements, the below described systems and methods compresses the data in the range cube into a block floating point format with a different mantissa bit lengths in order to save storage space. The bit length of mantissa values influences, for example, achievable dynamic range for processing using data produced by the slow time DFT, such as the dynamic range of Doppler shift calculations and somewhat influences calculations for Direction of Arrival (DOA).

In the following description, numerical values stored in a memory circuit are described as being represented by a mantissa value and an exponent value. A particular numerical value represented by a mantissa value and exponent value is a floating point value. The mantissa value and exponent value are referenced to a particular base number. Common base numbers used for such numerical values include, but are not limited to, ten (10), two (2), or any other number. The term mantissa refers to a fractional number by which the base number is multiplied and the exponent value is an exponential value by which the base value is raised. In various examples, the mantissa value is assumed to be preceded by a radix point (e.g., a decimal point). The particular value is determined by the combination of the mantissa multiplied by the base value where that value is multiplied by the base value raised to the exponent value. For example, with a base value of ten (10), a mantissa value of two hundred and fifty two (252) stored in a memory circuit and exponent value of three (3) stored in a memory circuit corresponds to a stored value of (.252) X 10³. In the below example, the example mantissa value of 252 can be fully stored in eight (8) bits. Storing this value in fewer than eight (8) bits will result in less accuracy.

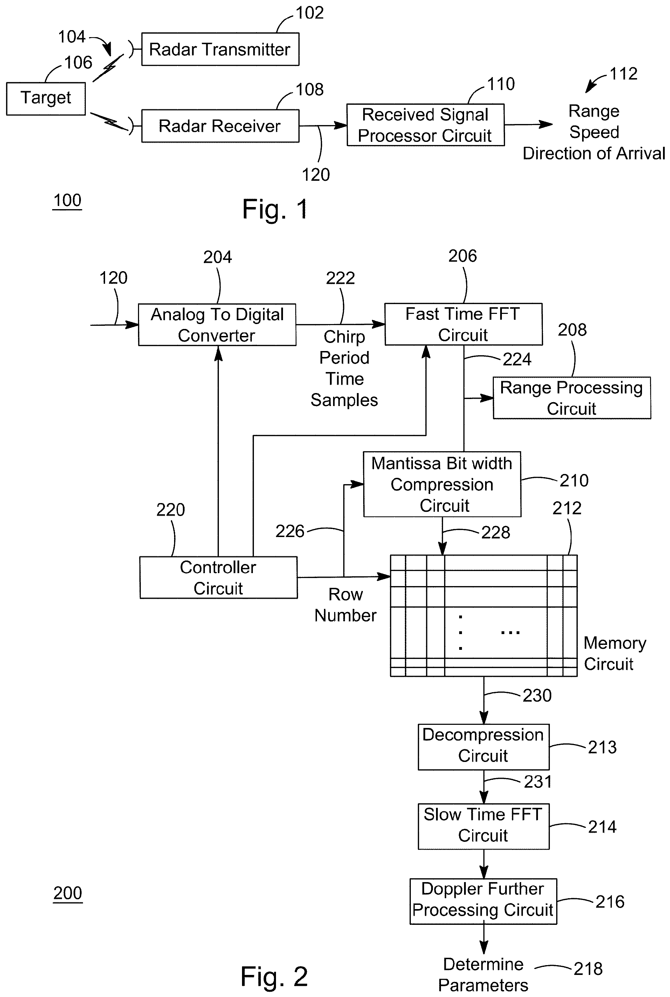

FIG. 1 illustrates a radar system 100, according to an example. The illustrated radar system 100 depicts a radar transmitter circuit 102 and a radar receiver circuit 108. The radar transmitter circuit 102 transmits a signal 104 that is reflected by a target 106 and received by the radar receiver circuit 108. In various examples the radar transmitter circuit 102 and the radar receiver circuit 108 are able to be part of a radar transceiver that both transmit and receive a signal. In some examples, the radar transmitter circuit 102 and radar receiver circuit 108 that transmits and receives the signal 104 are part of one radar transceiver that use one or multiple antennas to transmit and receive the signal 104. In further examples, the radar transmitter circuit 102 and the radar receiver circuit 108 are located in separate devices.

The radar receiver circuit 108 in the illustrated example produces a baseband signal 120 that is provided to a received signal processor circuit 110. The received signal processor circuit 110 is an example of a multi-dimensional DFT circuit that processes the baseband signal 120 to produce various determined parameters 112 for the target, including the listed determined parameters 112 of range, speed, and direction of arrival. In further examples, a subset of these parameters or other parameters are also able to be determined based on processing of the baseband signal 120 produced by the radar receiver circuit 108 based on the received signal 104.

In an example, the radar system 100 transmits and receives a signal 104 that is a Frequency Modulated Continuous Wave (FMCW) signal. As described above, an example of an FMCW signal, such as the signal 104 in an example, includes a sequence of chirp periods where each chirp period has a transmitted signal with a linearly increasing Radio Frequency (RF).

FIG. 2 illustrates a received signal processor block diagram 200, according to an example. The received signal processor block diagram 200 is an example of components included in an example of the received signal processor circuit 110. The received signal processor block diagram 200 is an example of a processor configured to perform multiple dimensional Discrete Fourier transforms (DFTs) and is thus an example of a multiple dimensional Discrete Fourier transform circuit.

The received signal processor block diagram 200 includes an Analog-to-Digital Converter (ADC) circuit 204. The operation of the ADC circuit 204 is controlled by timing circuits within a controller circuit 220 to synchronize the digitization of the baseband signal 120 such that chirp period time sample vectors 222 are produced that contain time samples of the baseband signal 120 that occur during each chirp period of a chirp sequence of a given number of chirp periods. In an example, the chirp sequence being processed has a number of chirp periods that correspond to a number of rows contained in a memory circuit storing DFTs of these time samples, as is described below.

A fast time Fast Fourier Transform (FFT) processing circuit 206 receives the chirp period time sample vectors 222 and, based on timing control provided by the controller circuit 220, performs an FFT on each time sample vector as it is received from the ADC circuit 204. The fast time FFT processing circuit 206 is an example of a processing block that performs a DFT on received time sample vectors to produce frequency domain vectors 224 representing the baseband signal 120 that is received during each received chirp period. A range processing circuit 208 in an example processes the produced frequency domain vectors 224 to determine range parameters for each target 106 that reflects the received radar signal 104. These range parameters are examples of target range information for the target 106.

The frequency domain vectors 224 in an example are accumulated for a sequence of chirp periods such that a respective frequency domain vector is stored for each of a plurality of chirp periods. In the illustrated example, these frequency domain vectors 224 are accumulated in a memory circuit 212, which is an example of a two-dimensional data structure memory circuit. The memory circuit 212 stores each element of the each of the frequency domain vectors 224 as a respective floating point data structure that has a respective mantissa and a respective exponent. Storing of the frequency domain vectors 224 into the memory circuit 212 is controlled by the controller circuit 220 that controls which row of the memory circuit 212 the presently received frequency domain vector is to be stored. In various examples, frequency domain vectors of a chirp sequence that contains chirp periods that make up one radar frame, or of chirp periods that make up a portion of a radar frame, are able to be accumulated into a set of data that is concurrently stored in the memory circuit 212.

In order to more efficiently store the accumulated frequency domain vectors 224, the frequency domain vectors 224 are compressed prior to storage into the memory circuit 212 by a mantissa bit length compression circuit 210 to produce compressed frequency domain vectors 228. The compressed frequency domain vectors 228 are examples of compressed data vectors that are stored into the memory circuit 212. The mantissa bit length compression circuit 210 in an example reduces the number of bits used to represent the mantissa of each data element while representing exponent values of each data element with equal number of bits. An example of the amount of mantissa bit length compression performed on various elements is described below.

The memory circuit 212, under control of the controller circuit 220, accumulates compressed frequency domain vectors 228 so as to fill all rows of the memory circuit 212. In an example, the memory circuit 212 stores data in a number of rows, which is generically referred to herein as "R" rows that are thus able to store "R" data vectors, where each row is able to store "C" data elements. The "C" data elements in each row are considered to form "C" columns in the two-dimensional data structure memory circuit 212. These columns are referred to as vertical columns in the two-dimensional metaphor of the two-dimensional data structure memory circuit 212. In an example, a chirp sequence containing "R" chirp periods.

Once each row in the memory is populated, a slow time FFT circuit 214, which is an example of a slow time DFT circuit, reads vertical column vectors 230 from vertical columns of the memory circuit 212. In an example, as the vertical column vectors 230 are read from the memory circuit 212, a decompression circuit 213 decompresses the stored data to restore the mantissa values of the elements in the retrieved vertical column vectors 230 to have the mantissa values of each data element represented by the same number of bits, i.e., have the same mantissa bit length.

The slow time FFT circuit 214 is referred to as a slow time process because its processing is generally paused until a complete set of frequency domain vectors 224 have been stored into the rows of the memory circuit 212. The slow time FFT circuit 214 reads and processes vertical column vectors 230 from the memory circuit 212, where each vertical column data vector contains frequency domain data values from the same frequency bin of the compressed frequency domain vectors 228.

The slow time FFT circuit 214 performs an FFT, which is an example of performing a DFT on each column vector. Prior to performing this FFT, the slow time FFT circuit 214 creates a number of windowed vectors by applying a windowing function to each column vector in the column vectors 230.

The slow time FFT circuit 214 provides calculated slow time FFT vectors 232 that were calculated for each of the column vectors 230 to a Doppler/further processing circuit 216. The illustrated Doppler/further processing circuit 216 is an example of a Doppler processing circuit and produces determined parameters 218. In various examples, the determined parameters 218 determined by the Doppler/further processing circuit 216 are able to include, but are not limited to, determined target velocity information regarding the target 106, direction of arrival information regarding received signals, other data, or combinations of these. In an example, the Doppler/further processing circuit 216 is able to perform processing on the calculated slow time FFT vectors 232 to determine Doppler shifts in the received signal to support determining velocity information regarding the target 106.

The Doppler/further processing circuit 216 is also able to store the calculated slow time FFT vectors 232 it receives from the slow time FFT circuit 214 in an additional data structure (not shown). In some examples, the data stored in that additional data structure is able to be compressed in a manner similar to the data stored in the memory circuit 212.

Returning to the mantissa bit length compression circuit 210, the mantissa bit length compression circuit 210 compresses frequency domain data to be stored in the memory circuit 212 by an amount that is determined based on the windowing function that will be applied by the slow time FFT circuit 214 to the stored data retrieved from the memory circuit 212 is read from the memory as column vectors 230. In the illustrated example, the amount of compression to be applied to each frequency domain vector being stored in the memory circuit 212 is determined based the row into which that frequency domain vector is to be stored. The amount of compression is determined based on the row into which the frequency domain vector is to be stored in this example because the row corresponds to a weight value of the weighting function applied to the retrieved column vectors by the slow time FFT circuit 214.

In the illustrated example, a mantissa bit length compression circuit 210 compresses the data stored in the memory circuit 212 in a manner described in further detail below. The mantissa bit length compression circuit 210 receives the frequency domain vectors 224 and an indication of the row 226 into which the frequency domain vector presently received from the fast time FFT processing circuit 206. In an example, the amount of compression performed by the mantissa bit length compression circuit 210 is based on a value of the windowing function applied to the data in the row into which the present frequency domain vector is being stored.

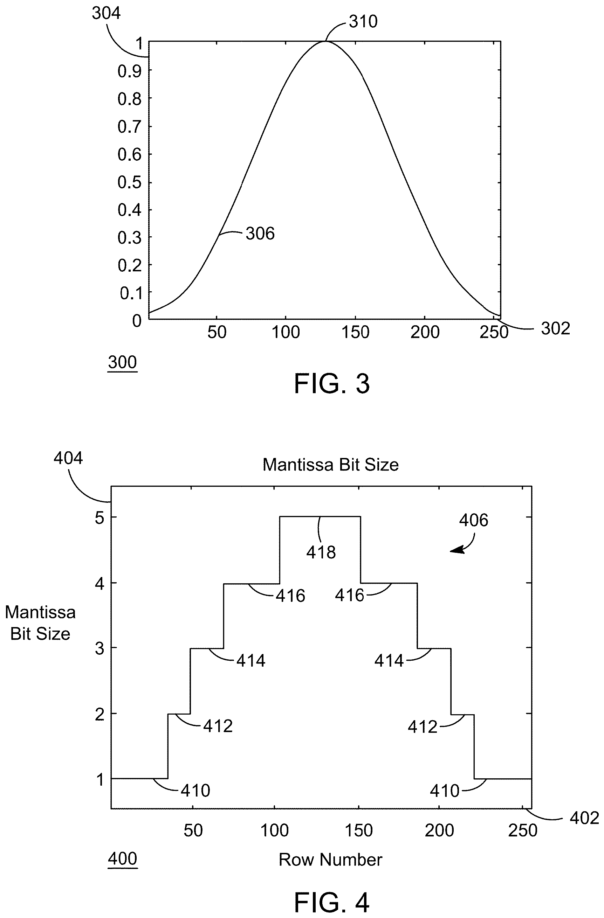

FIG. 3 illustrates a windowing function 300, according to an example. The windowing function 300 depicts weight values applied to, for example, column vectors that are read from the memory circuit 212 as described above. These column vectors are the input to the slow time FFT circuit 214. Windowing functions are applied to data vectors prior to performing discrete Fourier transforms in order to mitigate spectral leakage when calculating the DFT.

The illustrated windowing function 300 depicts a horizontal axis 302, which indicates element numbers of a data vector to which the windowing function 300 is applied. A vertical axis 304 indicates the value of the windowing function weight value that is applied to particular element numbers. The illustrated windowing function 300 depicts weights applied to a data vector that has two hundred and fifty six (256) elements as is indicated by the value range of the horizontal axis 302. The windowing function further depicts a windowing weight curve 306 that indicates windowing function weight values that are applied to the elements of data vectors. The windowing weight curve indicates weight values between slightly above zero for samples zero (0) and two hundred and fifty-six (265), and that the weight values increase towards values approaching one (1) in the vicinity of sample one hundred and twenty-eight (128). In some examples, the windowing functions have a fixed value for each weight.

FIG. 4 illustrates a mantissa bit length vs. data vector sample number curve 400, according to an example. The mantissa bit length vs. data vector sample number curve 400 illustrates a data compression technique used to store data into the above described memory circuit 212. The data compression in this example compresses data stored in the memory circuit 212 based on a respective weight value of a windowing function that is applied to the stored elements when those elements are read from the memory circuit 212 for further processing.

The mantissa bit length vs. data vector sample number curve 400 has a horizontal axis 402 that indicates the row number of the memory circuit 212. The mantissa bit length vs. data vector sample number curve 400 has a mantissa bit length curve 406 that indicates, as is reflected by the values of the vertical axis 404 that indicate mantissa bit length, how many bits are used to store each element value in a particular row number as indicated by the horizontal axis 402.

The mantissa bit length vs. data vector sample number curve 400 depicts two (2) one bit mantissa row ranges 410, two (2) two bit mantissa row ranges 412, two (2) three bit mantissa row ranges 414, two (2) four bit mantissa row ranges 416, and a five bit mantissa row range 418. In the present discussion, a reference to an N bit mantissa bit range refers to row numbers in the memory circuit 212 that store mantissa values in N bits, i.e., have a mantissa bit length of N. In the illustrated example, the one bit mantissa row ranges extend from row one (1) to row thirty two (32) and from row two-hundred and twenty four (224) to row two-hundred and fifty six (256). It is pointed out that the general shape of the mantissa bit length curve 406 follows the shape of the windowing weight curve 306. In various examples, the mantissa bit length curve 406 is able to be symmetrical or non-symmetrical along the row numbers indicated by the horizontal axis 402. The row number at which the mantissa bit length curve 406 changes between different mantissa bit lengths is able to be adjusted in various examples in order to achieve various performance objectives.

The illustrated examples compress data to be stored in the memory circuit 212 by allocating mantissa bit lengths to the compressed values according to the weights of the window function that that will be applied to that value. Such a data compression technique with a memory circuit 212 of a given memory size provides a better tradeoff between storage space and achievable dynamic range of signal processing based on that data than can be achieved by using a uniform mantissa bit lengths for all values stored in memory of the same given memory size. In these examples, values on the ends of the data vector that have a lower windowing function weight value applied to them are more strongly compressed so that more storage space is able to be used for values in the middle of the data vector that have larger windowing function weight values applied to them.

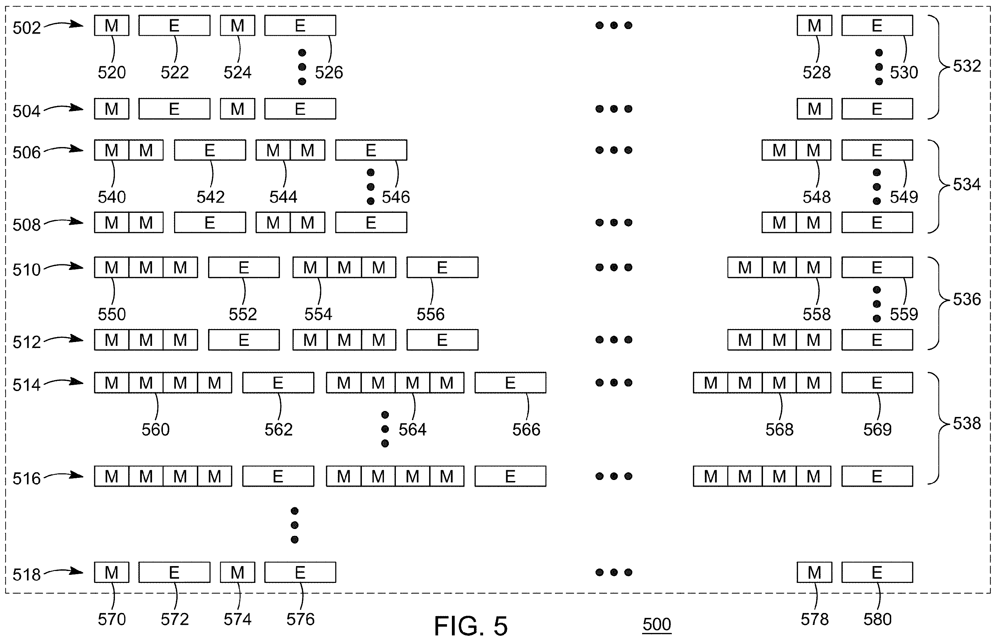

FIG. 5 illustrates a compressed data memory organization 500, according to an example. The compressed data memory organization depicts data stored in a memory circuit 212 that has been compressed according to the above described mantissa bit length curve 406. The compressed data memory organization 500 illustrates a number of rows of the memory circuit 212 where each row in the illustrated example contains equal numbers of data elements. As described above with regards to the memory circuit 212 and slow time FFT circuit 214, data elements are read as column vectors where each column vector contains one data element from each row of the memory circuit 212 that is stored in a particular column. In the example with an mantissa bit length vs. data vector sample number curve 400 described above, the memory circuit 212 has two hundred and fifty-six (256) rows, where each column vector has two hundred and fifty-six (256) elements. These elements have the windowing weight curve 306 applied to their values.

The illustrated compressed data memory organization 500 stores data elements as real numbers that all have exponent values encoded into the same number of exponent bits. The data elements are stored in rows where the data elements have mantissa values encoded into a number of bits according to the mantissa bit length vs. data vector sample number curve 400 as is described above. Using different numbers of mantissa bits for each data element based on the weight value of the window to be applied to data read from that row allows more effective compression of data stored in the memory circuit 212 when considered in combination with the processing applied subsequently to that data.

As shown, the compressed data memory organization 500 depicts a number of rows of the memory circuit 212, which is an example of a two-dimensional data structure memory circuit. The compressed data memory organization 500 has a first row 502, a second row 504, a third row 506, a fourth row 508, a fifth row 510, a sixth row 512, a seventh row 514, an eight row 516 and a last row 518. These rows are shown as constituting groups of rows where different groups of rows store data values with mantissa values stored with different numbers of bits and thus have different mantissa bit lengths.

A first group 532 is shown to include the first row 502, the second row 504, and a number of rows in between. Ellipses between the first row 502 and the second row 504 indicate the number of rows within the first group 532. The first group 532 includes the number of rows that corresponds to the length of one of the one bit mantissa row ranges 410 described above. The illustration of the first row 502 depicts a first row first data element with a first mantissa 520 and a first exponent 522, a first row second data element with a first row second mantissa 524 and a first row second exponent 526, and a first row last data element that has a first row last mantissa 528 and a first row last exponent 530. The single "M" in each mantissa of the first row 502 indicates that only one (1) bit is used to encode the mantissa value for those data elements, i.e., these values have a mantissa bit length of one (1). The second row 504 is shown to store data elements with a structure similar to the first row 502, i.e., each data element is stored with a one bit mantissa value. Ellipses between the first row second data element and the first row last data element indicate the intermediate elements in those rows. As noted above, all rows in the illustrated compressed data memory organization 500 have the same number of data elements. The amount of memory used to store each row of data does, however, vary due to the different number of bits used to store the mantissa values of data elements stored in the various rows.

A second group 534 is shown to include the third row 506, the fourth row 508, and a number of rows in between, with ellipses indicating the number of rows within the second group 534 between the third row 506 and the fourth row 508. The second group 534 includes the number of rows that corresponds to the length of one of the two bit mantissa row ranges 412 described above. The third row 504 has a third row first data element with a third row first mantissa 540 and a third row first exponent 542, a second data element with a third row second mantissa 544 and a third row second exponent 546, and a third row last data element with a third row last mantissa 548 and a third row last exponent 549. Ellipses between the third row second data element and the third row last data element indicate the intermediate elements in the third row. The two "M"s in each mantissa of the third row 506 indicate that data elements in the third row are encoded with mantissa values having two (2) bits, i.e., have a mantissa bit length of two (2). The fourth row 508 is shown to store data elements with a structure similar to the third row 506, i.e., each data element is stored with mantissa values having two bits.

A third group 536 is shown to include the fifth row 510, the sixth row 512, and a number of rows in between, with ellipses indicating the number of rows within the third group 536 between the fifth row 510 and the sixth row 512. The third group 536 includes the number of rows that corresponds to the length of one of the three bit mantissa row ranges 416 described above. The fifth row 504 has a fifth row first data element with a fifth row first mantissa 550 and a fifth row first exponent 552, a fifth row second data element with a fifth row second mantissa 554 and a fifth row second exponent 556, and a fifth row last data element with a fifth row last mantissa 558 and a fifth row last exponent 559. Ellipses between the fifth row second data element and the fifth row last data element indicate the remainder of elements in the fifth row. The three "M"s in each mantissa of the fifth row 510 indicate that data elements in the fifth row are encoded with mantissa values having three (3) bits. The sixth row 512 is shown to store data elements with a structure similar to the fifth row 510, i.e., each data element is stored with mantissa values having three bits.

A fourth group 538 is shown to include the seventh row 514, the eight row 516, and a number of rows in between, with ellipses indicating the number of rows within the fourth group 538 between the seventh row 514 and the eight row 516. The fourth group 538 includes the number of rows that corresponds to the length of one of the four bit mantissa row ranges 418 described above. The seventh row 514 has a seventh row first data element with a seventh row first mantissa 560 and a seventh row first exponent 562, a seventh row second data element with a seventh row second mantissa 564 and a seventh row second exponent 566, and a seventh row last data element with a seventh row last mantissa 568 and a seventh row last exponent 569. Ellipses between the seventh row second data element and the seventh row last data element indicate the remainder of elements in the seventh row. The four "M"s in each mantissa of the seventh row 514 indicate that data elements in the seventh row are encoded with mantissa values having four (4) bits. The eight row 516 is shown to store data elements with a structure similar to the seventh row 514, i.e., each data element is stored with mantissa values having four bits.

The compressed data memory organization 500 depicts a last row 518 that has a last row first data element with a last row first mantissa 570 and a last row first exponent 572, a last row second data element with a last row second mantissa 574 and a last row second exponent 576, and a last row last data element with a last row last element mantissa 578 and a last row last exponent 580. The last row first mantissa, 570, last row second mantissa 574, and last row last element mantissa 578 are depicted with one (1) "M." As is consistent with the mantissa bit length vs. data vector sample number curve 400, the last row, which corresponds to row two hundred and fifty six (256) in the mantissa bit length vs. data vector sample number curve 400, is part of a group of rows similar to the first group 532 that has a number of data elements encoded with one (1) mantissa bit. Ellipses between the eight row 516 and the last row 518 depict the remainder of the rows within the memory circuit 212 where those rows store data elements with mantissa values having the number of bits indicated by the mantissa bit length vs. data vector sample number curve 400.

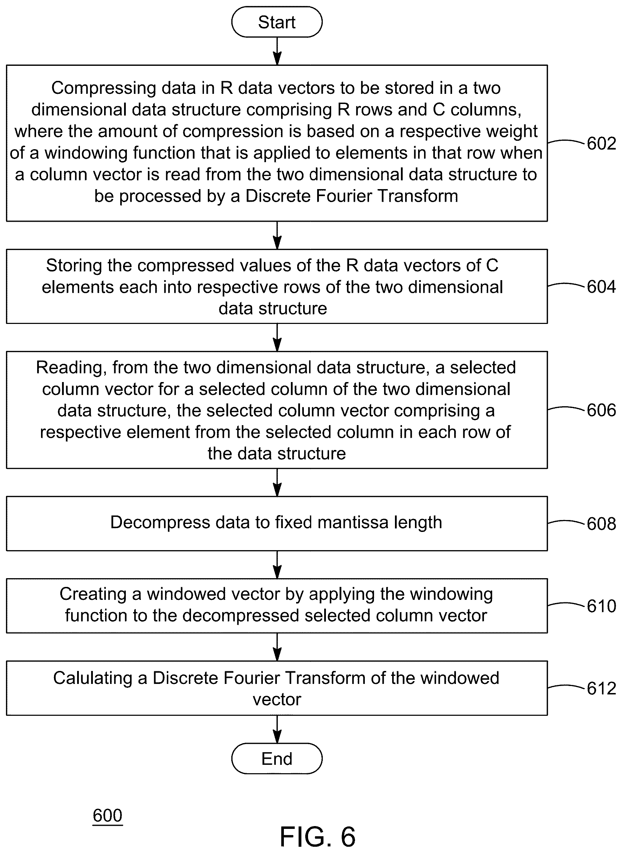

FIG. 6 illustrates a two-dimensional data compression process 600, according to an example. The two-dimensional data compression process 600 is an example of a process performed by a multi-dimensional DFT circuit such as is describe above with regards to the controller circuit 220 operating in conjunction with the mantissa bit length compression circuit 210, memory circuit 212, and the slow time FFT circuit 214 to compress data stored in a two-dimensional data structure memory circuit, such as the above described memory circuit 212.

The two-dimensional data compression process 600 includes compressing, at 602, data in R data vectors, which correspond to R chirp periods within a chirp sequence, to be stored in a two-dimensional data structure memory circuit comprising R rows and C columns. In an example, the two-dimensional data structure memory circuit has R equal to two hundred and fifty-six (256) rows. In such an example, the two-dimensional structure memory circuit has C equal to two hundred and fifty-six (256) columns. In an example, the amount of compression applied to the data is based on a respective weight of a windowing function that is applied to elements in that row when a column vector is read from the two-dimensional data structure memory circuit to be processed by a Discrete Fourier Transform.

The compressed values of the R data vectors of C elements are each stored into respective rows of the two-dimensional data structure memory circuit, at 604. In an example, the R data vectors are sequentially stored in into the two-dimensional data storage memory circuit in the order in which the signals from which they were derived were received.

A selected column vector for a selected column of the two-dimensional data structure memory circuit is read from the two-dimensional data structure memory circuit, at 606. The selected column vector is made up of a respective element from the selected column in each row of the two-dimensional data structure memory circuit.

The data within the selected column vector that is read from the two-dimensional data structure memory circuit is decompressed, at 608. Such decompression is performed by expanding the mantissa values of all data elements in the selected column vector such that all data elements have mantissa values represented by the same number of bits.

A windowed vector is created, at 610, by applying the windowing function to the decompressed selected column vector. An example windowing function is described above with respect to the windowing function 300. In an example, the windowed vector is created by multiplying each element of the selected column vector by a weight to be applied to that element.

A DFT of the windowed vector is calculated, at 612. In an example, the DFT is performed by calculating a FFT of the windowed vector, such as is described above with regards to the slow time FFT circuit 214. The two-dimensional data compression process 600 then ends.

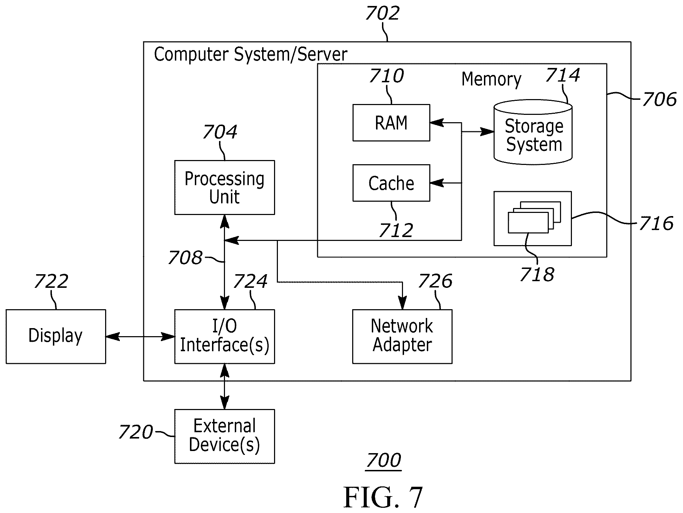

FIG. 7 is a block diagram illustrating an information processing system 700 that can be utilized by one or more examples discussed herein. The computer system/server 702 is based upon a suitably configured processing system configured to implement one or more embodiments of the present invention, such as elements of the above described radar system 100 and the received signal processor block diagram 200. Any suitably configured processing system, including specialized processing systems, can be used as the computer system/server 702. Alternatively, to the described information processing system 700, further examples are able to be implemented in relatively small, limited purpose processors to implement the above described processing. In an example, such processors are able to be integrated with or nearby battery cell packs that are deployed in various applications. Examples of these processors are able to include any combination of general purpose processing hardware, dedicated processing hardware such as dedicated multiply and accumulate circuits, other elements, or combinations of these.

The components of the computer system/server 702 can include but are not limited to, one or more processors, processing circuits, or processing units 704, a system memory 706, and a bus 708 that couples various system components including the system memory 706 to the processing units 704. The bus 708 represents one or more of any of several types of bus structures, including a memory bus or memory controller, a peripheral bus, an accelerated graphics port, and a processor or local bus using any of a variety of bus architectures. By way of example, and not limitation, such architectures include Industry Standard Architecture (ISA) bus, Micro Channel Architecture (MCA) bus, Enhanced ISA (EISA) bus, Video Electronics Standards Association (VESA) local bus, and Peripheral Component Interconnects (PCI) bus.

The system memory 706 can include computer system readable media in the form of volatile memory, such as random access memory (RAM) 710 and/or cache memory 712. The computer system/server 702 can further include other removable/non-removable, volatile/non-volatile computer system storage media. By way of example only, a storage system 714 can be provided for reading from and writing to a non-removable or removable, non-volatile media such as one or more solid-state disks and/or magnetic media (typically called a "hard drive"). A magnetic disk drive for reading from and writing to a removable, non-volatile magnetic disk (e.g., a "floppy disk"), and an optical disk drive for reading from or writing to a removable, non-volatile optical disk such as a CD-ROM, DVD-ROM or other optical media can be provided. In such instances, each can be connected to the bus 708 by one or more data media interfaces. The system memory 706 can include at least one program product having a set of program modules that are configured to carry out the functions of an example of the present disclosure.

Program/utility 716, having a set of program modules 718, may be stored in system memory 706 by way of example, and not limitation, as well as an operating system, one or more application programs, other program modules, and program data. Each of the operating system, one or more application programs, other program modules, and program data or some combination thereof, may include an implementation of a networking environment. Program modules 718 generally carry out the functions and/or methodologies of examples of the present disclosure.

The computer system/server 702 can also communicate with one or more external devices 720 such as a keyboard, a pointing device, a display 722, etc.; one or more devices that enable a user to interact with the computer system/server 702; and/or any devices, e.g., network card, modem, etc., that enable computer system/server 702 to communicate with one or more other computing devices. Such communication can occur via I/O interfaces 724. Still yet, the computer system/server 702 can communicate with one or more networks such as a local area network (LAN), a general wide area network (WAN), and/or a public network, e.g., the Internet, via network adapter 726. As depicted, the network adapter 726 communicates with the other components of the computer system/server 702 via the bus 708. Other hardware and/or software components can also be used in conjunction with the information processing system 700.

In an example, a method of performing multiple dimensional Discrete Fourier Transforms includes compressing, to create compressed data vectors, data in R data vectors (602) that each comprise C elements to be stored in a two-dimensional data structure memory circuit (212) comprising R rows and C columns, where an amount of compression is based on a respective weight of a windowing function that is applied to elements in that row when a column vector is read from the two-dimensional data structure memory circuit to create a windowed vector. This example further includes storing (604) the compressed data vectors into the two-dimensional data structure memory circuit and reading (606), from the two-dimensional data structure memory circuit, a selected column vector for a selected column of the two-dimensional data structure memory circuit, where the selected column vector comprising a respective element from the selected column in each row of the two-dimensional data structure memory circuit. This example further includes creating (610) the windowed vector by applying a windowing function (306) to the selected column vector. In this example, the windowing function applies a weight to each element in the selected column vector. This example further includes calculating a Discrete Fourier Transform of the windowed vector (612).

In another example, a multi-dimensional Discrete Fourier Transform circuit (110) includes a mantissa bit length compression circuit (210) that, when operating compresses, to create compressed data vectors, data in R data vectors (602) that each comprise C elements to be stored in a two-dimensional data structure memory circuit (212) comprising R rows and C columns, where an amount of compression is based on a respective weight of a windowing function that is applied to elements in that row when a column vector is read from the two-dimensional data structure memory circuit to create a windowed vector. The mantissa bit length compression circuit stores the compressed data vectors into the two-dimensional data structure memory circuit (604). This example further includes a slow time Discrete Fourier Transform circuit (214) that, when operating: reads, from the two-dimensional data structure memory circuit, a selected column vector for a selected column of the two-dimensional data structure memory circuit (606), where the selected column vector comprising a respective element from the selected column in each row of the two-dimensional data structure memory circuit. The slow time Discrete Fourier Transform circuit creates (610) the windowed vector by applying a windowing function to the selected column vector, wherein the windowing function applies a weight to each element in the selected column vector. The slow time Discrete Fourier Transform circuit in this example further calculates a Discrete Fourier Transform of the windowed vector (612).

In a further example, a computer program product (718) for performing multiple dimensional Discrete Fourier Transforms includes a computer readable storage medium (714) having computer readable program code embodied therewith, the computer readable program code comprising instructions for performing a method. The method of this example includes compressing, to create compressed data vectors, data in R data vectors (602) that each comprise C elements to be stored in a two-dimensional data structure memory circuit (212) comprising R rows and C columns, where an amount of compression is based on a respective weight of a windowing function that is applied to elements in that row when a column vector is read from the two-dimensional data structure memory circuit to create a windowed vector. This example further includes storing (604) the compressed data vectors into the two-dimensional data structure memory circuit and reading (606), from the two-dimensional data structure memory circuit, a selected column vector for a selected column of the two-dimensional data structure memory circuit, where the selected column vector comprising a respective element from the selected column in each row of the two-dimensional data structure memory circuit. This example further includes creating (610) the windowed vector by applying a windowing function (306) to the selected column vector. In this example, the windowing function applies a weight to each element in the selected column vector. This example further includes calculating a Discrete Fourier Transform of the windowed vector (612).

The term "coupled", as used herein, is defined as "connected" and encompasses the coupling of devices that may be physically, electrically or communicatively connected, although the coupling may not necessarily be directly and not necessarily be mechanical. The term "configured to" describes hardware, software, or a combination of hardware and software that is adapted to, set up, arranged, built, composed, constructed, designed, or that has any combination of these characteristics to carry out a given function. The term "adapted to" describes hardware, software, or a combination of hardware and software that is capable of, able to accommodate, to make, or that is suitable to carry out a given function.

The terms "a" or "an", as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to invention embodiments containing only one such element, even when the same claim includes the introductory phrases "one or more" or "at least one" and indefinite articles such as "a" or "an". The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The term "coupled", as used herein, is not intended to be limited to a direct coupling or a mechanical coupling, and that one or more additional elements may be interposed between two elements that are coupled.

As will be appreciated by one skilled in the art, aspects of the present disclosure may be embodied as a system, method, or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "circuit" or "system".

The one or more embodiments of the invention may be a system, a method, and/or a computer program product. The computer program product may include a computer-readable storage medium (or media) having computer readable program instructions thereon for causing a processor to carry out aspects of the inventive embodiments.

In one embodiment, the computer program product includes a non-transitory storage medium readable by a processing circuit and storing instructions for execution by the processing circuit for performing a method. The computer-readable storage medium can be a tangible device that can retain and store instructions for use by an instruction execution device. The computer-readable storage medium may be, for example, but is not limited to, an electronic storage device, a magnetic storage device, an optical storage device, an electromagnetic storage device, a semiconductor storage device, or any suitable combination of the foregoing. A computer-readable storage medium, as used herein, is not to be construed as being transitory signals per se, such as radio waves or other freely propagating electromagnetic waves, electromagnetic waves propagating through a waveguide or other transmission media, e.g., light pulses passing through a fiber-optic cable), or electrical signals transmitted through a wire.

Computer-readable program instructions for carrying out operations of the inventive embodiments may be assembler instructions, instruction-set-architecture (ISA) instructions, machine instructions, machine-dependent instructions, microcode, firmware instructions, state-setting data, or either source code or object code written in any combination of one or more programming languages, including an object-oriented programming language such as Smalltalk, C++, and conventional procedural programming languages, such as the "C" programming language or similar programming languages. The computer-readable program instructions may execute entirely or partly on a user's computer or entirely or partly on a remote computer or server. In the latter scenario, the remote computer may be connected to the user's computer through any type of network, including a local area network (LAN), a wide area network (WAN), an Ultra-Wide Band (UWB) network, or the connection may be made to an external computer (for example, through the Internet). In some embodiments, electronic circuitry including, for example, programmable logic circuitry, field-programmable gate arrays (FPGA), or programmable logic arrays (PLA) may execute the computer-readable program instructions by utilizing state information of the computer-readable program instructions to personalize the electronic circuitry, in order to perform aspects of the inventive embodiments.

Aspects of one or more embodiments of the invention are described herein with reference to flowchart illustrations and/or block diagrams of methods, apparatus (systems), and computer program products according to embodiments of the invention. Each block of the flowchart illustrations and/or block diagrams, and combinations of blocks in the flowchart illustrations and/or block diagrams, can be implemented by computer readable program instructions.

These computer-readable program instructions may be provided to a processor of a general-purpose computer, special purpose computer, or other programmable data processing apparatus to produce a machine, such that the instructions, which execute via the processor of the computer, create means for implementing the functions/acts specified in the flowchart and/or block diagram blocks. These computer-readable program instructions may also be stored in a computer-readable storage medium that can direct a computer to function in a particular manner, such that the computer-readable storage medium having instructions stored therein comprises an article of manufacture including instructions which implement aspects of the function/act specified in the flowchart and/or block diagram block or blocks.

The description of the present disclosure has been presented for purposes of illustration and description but is not intended to be exhaustive or limited to the inventive embodiments in the form disclosed. Many modifications and variations will be apparent to those of ordinary skill in the art without departing from the scope and spirit of the inventive embodiments. One or more embodiments were chosen and described in order to best explain the principles of the inventive subject matter and the practical application and to enable others of ordinary skill in the art to understand the inventive subject matter for various embodiments with various modifications as are suited to the particular use contemplated.

Although specific embodiments of the invention have been disclosed, those having ordinary skill in the art will understand that changes can be made to the specific embodiments without departing from the spirit and scope of the inventive embodiments. The scope of the inventive subject matter is not to be restricted, therefore, to the specific embodiments, and it is intended that the appended claims cover any and all such applications, modifications, and embodiments within the scope of the inventive subject matter.

## Claims

1. A method of performing multiple dimensional Discrete Fourier Transforms, the method comprising:
compressing, to create compressed data vectors, data in R data vectors that each comprise C elements to be stored in a two-dimensional data structure memory circuit comprising R rows and C columns, where an amount of compression is based on a respective weight of a windowing function that is applied to elements in that row when a column vector is read from the two-dimensional data structure memory circuit to create a windowed vector;
storing the compressed data vectors into the two-dimensional data structure memory circuit;
reading, from the two-dimensional data structure memory circuit, a selected column vector for a selected column of the two-dimensional data structure memory circuit, the selected column vector comprising a respective element from the selected column in each row of the two-dimensional data structure memory circuit;
creating the windowed vector by applying a windowing function to the selected column vector, wherein the windowing function applies a weight to each element in the selected column vector; and
calculating a Discrete Fourier Transform of the windowed vector.

2. The method of claim 1, wherein the Discrete Fourier Transform is a Fast Fourier Transform.

3. The method of claim 1 or 2, wherein the two-dimensional data structure memory circuit stores each element as a respective floating point data structure, where each respective element comprises:
a respective mantissa with a respective number of mantissa bits; and
a respective exponent with a respective number of exponent bits, and
wherein compressing data stored in each row comprising determining a respective number of mantissa bits for each respective element based on a respective value of the respective weight applied to the elements in that respective row in the selected column vector.

4. The method of any preceding claim, further comprising:
reading, from the two-dimensional data structure memory circuit, a respective selected column vector for a plurality of columns of the two-dimensional data structure memory circuit, wherein each respective selected column vector comprises a respective element from a respective selected column in each row of the two-dimensional data structure memory circuit;
creating a plurality of windowed vectors by applying a windowing function to each respective selected column vector, wherein the windowing function applies a respective weight to each element in the respective selected column vector; and
calculating a respective Discrete Fourier Transform of each of the windowed vectors in the plurality of windowed vectors.

5. The method of any preceding claim, wherein the windowing function is created to mitigate spectral leakage when calculating the Discrete Fourier Transform, and wherein the windowing function comprises a respective fixed value for each respective weight.

6. The method of any preceding claim, wherein each data vector in the R data vectors comprises a respective Discrete Fourier Transform of a respective received Frequency Modulated Continuous Wave (FMCW) chirp period within a chirp sequence of R chirp periods.

7. The method of claim 6, further comprising:
determining target range information based on at least some of the R data vectors; and
determining target velocity information based on the Discrete Fourier Transform of the windowed vector.

8. A multi-dimensional Discrete Fourier Transform circuit, comprising:
a mantissa bit length compression circuit that, when operating:
compresses, to create compressed data vectors, data in R data vectors that each comprise C elements to be stored in a two-dimensional data structure memory circuit comprising R rows and C columns, where an amount of compression is based on a respective weight of a windowing function that is applied to elements in that row when a column vector is read from the two-dimensional data structure memory circuit to create a windowed vector; and
stores the compressed data vectors into the two-dimensional data structure memory circuit;
a slow time Discrete Fourier Transform circuit that, when operating:
reads, from the two-dimensional data structure memory circuit, a selected column vector for a selected column of the two-dimensional data structure memory circuit, the selected column vector comprising a respective element from the selected column in each row of the two-dimensional data structure memory circuit;
creates the windowed vector by applying a windowing function to the selected column vector, wherein the windowing function applies a weight to each element in the selected column vector; and
calculates a Discrete Fourier Transform of the windowed vector.

9. The multi-dimensional Discrete Fourier Transform circuit of claim 8, wherein the Discrete Fourier Transform is a Fast Fourier Transform.

10. The multi-dimensional Discrete Fourier Transform circuit of claim 8 or 9, wherein the two-dimensional data structure memory circuit stores each element as a respective floating point data structure, where each respective element comprises:
a respective mantissa with a respective number of mantissa bits; and
a respective exponent with a respective number of exponent bits, and
wherein compressing data stored in each row comprising determining a respective number of mantissa bits for each respective element based on a respective value of the respective weight applied to the elements in that respective row in the selected column vector.

11. The multi-dimensional Discrete Fourier Transform circuit of any of claims 8 to 10, wherein the slow time Discrete Fourier Transform circuit, when operating, further:
reads, from the two-dimensional data structure memory circuit, a respective selected column vector for a plurality of columns of the two-dimensional data structure memory circuit, wherein the respective selected column vector comprises a respective element from a respective selected column in each row of the two-dimensional data structure memory circuit;
creates a plurality of windowed vectors applying a windowing function to each respective selected column vector, wherein the windowing function applies a respective weight to each element in the respective selected column vector; and
calculates a respective Discrete Fourier Transform of each of the windowed vectors in the plurality of windowed vectors.

12. The multi-dimensional Discrete Fourier Transform circuit of any of claim 8 to 11, wherein the windowing function is created to mitigate spectral leakage when calculating the Discrete Fourier Transform, and wherein the windowing function comprises a respective fixed value for each respective weight.

13. The multi-dimensional Discrete Fourier Transform circuit of any of claims 8 to 12, wherein each data vector in the R data vectors comprises a respective Discrete Fourier Transform of a respective received Frequency Modulated Continuous Wave (FMCW) chirp period within a chirp sequence of R chirp periods.

14. The multi-dimensional Discrete Fourier Transform circuit of claim 13, further comprising a Doppler processing circuit that, when operating, is configured to:
determine target range information based on at least some of the R data vectors; and
determine target velocity information based on the Discrete Fourier Transform of the windowed vector.

15. A computer program product for performing multiple dimensional Discrete Fourier Transforms, the computer program product comprising:
a computer readable storage medium having computer readable program code embodied therewith, the computer readable program code comprising instructions for performing a method comprising:
compressing, to create compressed data vectors, data in R data vectors that each comprise C elements to be stored in a two-dimensional data structure memory circuit comprising R rows and C columns, where an amount of compression is based on a respective weight of a windowing function that is applied to elements in that row when a column vector is read from the two-dimensional data structure memory circuit to create a windowed vector;
storing the compressed data vectors into the two-dimensional data structure memory circuit;
reading, from the two-dimensional data structure memory circuit, a selected column vector for a selected column of the two-dimensional data structure memory circuit, the selected column vector comprising a respective element from the selected column in each row of the two-dimensional data structure memory circuit;
creating the windowed vector by applying a windowing function to the selected column vector, wherein the windowing function applies a weight to each element in the selected column vector; and
calculating a Discrete Fourier Transform of the windowed vector.
